# EUROPEAN PATENT APPLICATION

(11) **EP 3 764 118 A1**
(43) Date of publication of application: **13.01.2021**
(21) Application number: 19185661.6
(22) Date of filing: 11.07.2019
(51) Int. Cl.: G01R 33/565

(54) **AN APPARATUS AND METHOD FOR MEDICAL IMAGE CORRECTION**

(71) Applicant: Koninklijke Philips N.V., 5656 AG Eindhoven (NL)
(72) Inventor: ZHANG, Yajing, 5656 AE Eindhoven (NL); WU, Peng, 5656 AE Eindhoven (NL); ZHAO, Chen Guang, 5656 AE Eindhoven (NL)
(74) Representative: de Haan, Poul Erik

(57) **Abstract**

Embodiment of the present invention provides a method for generating a quality degradation model of an imaging system with a hardware imperfection. The method comprises the steps of obtaining a first image from a first simulation of the imaging system without the hardware imperfection, obtaining a second image from a second simulation of the imaging system with the hardware imperfection, and generating the quality degradation model learnt with a mapping function from an input degraded image measured from the imaging system to an output corrected image based on a plurality of input and out image pairs. The input image in each image pair comprises the second image, and the output image in each image pair comprises the first image. The quality degradation from the output image to the input image in each image pair characterizes a type of quality degradation specific to the hardware imperfection.

## Description

### FIELD OF THE INVENTION

The invention relates to image correction and more particularly to correct the distortion or artifacts in medical images caused by hardware imperfection of medical imaging systems.

### BACKGROUND OF THE INVENTION

A medical imaging device usually contains two parts: signal emitting part and signal receiving part. The signal emitting part sends a particular kind of signal (like radiofrequency pulse, ultrasound, x-ray, etc.) to tissues. This signal is then modulated by the tissue, and collected by the receiving part. The received signal is used to produce diagnostic images. Ideally, these diagnostic images are highly coincided with tissue properties, which can be described as 'high fidelity'. While, it is difficult to achieve high fidelity images due to degraded system response features, which in turn is a result of system hardware imperfection, such as main magnetic uniformity, transmit inhomogeneity, gradient non-linearity, eddy current, and chain variability etc., in MRI, or the sensitivity and precision of the detectors in Ultrasound and CT systems.

In most cases, it is not feasible to analytically describe the system response function of a medical imaging device, and therefore it is impractical to inversely recover the images with high fidelity using conventional image processing methods. While many machine learning applications are applied on image analysis domain to learn the correspondence between input images and output labels, it suffers from a lack of availability of training medical image data corrupted by the specific type of image degradation associated with the system hardware imperfection and high fidelity medical images that don't suffer from the system hardware imperfection as output labels and input images respectively, since all medial images measured from the imaging system carry the distortion associated with the system hardware imperfection.

### SUMMARY OF THE INVENTION

From the foregoing, it is readily appreciated that there is a need to provide a solution to correct the type of distortion caused by hardware imperfection of the medical imaging system. Moreover, it is desirable to apply the machine learning technology in medical imaging domain. It is consequently an object of the invention to provide a method for generating a quality degradation model of an imaging system with a hardware imperfection, an apparatus for medical image correction, a method for correcting quality degradation in a medical image, a computer program thereof in the independent claims. Embodiments are given in the dependent claims.

Embodiments of the present invention provide a method for correcting a type of quality degradation specific to a hardware imperfection of an imaging system in a medical image . The method comprises the steps of obtaining a first image from a first simulation of the imaging system without the hardware imperfection, obtaining a second image from a second simulation of the imaging system with the hardware imperfection, and generating the quality degradation model learnt with a mapping function from an input degraded image measured from the imaging system to an output corrected image based on a plurality of input and out image pairs. The input image in each image pair comprises the second image, and the output image in each image pair comprises the first image. The quality degradation from the output image to the input image in each image pair characterizes a type of quality degradation specific to the hardware imperfection. By applying the quality degradation model to the medical image, the type of quality degradation specific to the hardware imperfection of the imaging system in the medical image can be corrected.

Advantageously, simulation of a medical imaging system can provide a high fidelity image that does not suffer from any distortion caused by the inherent hardware imperfection of the medical image system. Furthermore, simulation of the medical imaging system can also provide a distorted medical image suffering from a type of distortion specific to a given hardware imperfection. As such, the quality degradation from the distorted medical image to the high fidelity image characterizes the type of quality degradation specific to the given hardware imperfection. Clinical measurements from medical imaging systems can be avoided for sufficient availability of such image pairs since they are obtained from computer-implemented simulations. Sufficient availability of training image pairs further enables the application of machine learning technology in medical image domain, which is gaining more and more popularity in the current era.

According to one embodiment of the present invention, the method further comprises the steps of obtaining a virtual object by a simulator of the imaging system, generating the first image of the virtual object by the simulator configured without the hardware imperfection, and generating the second image of the virtual object by the simulator configured with the hardware imperfection. Advantageously, by configuring and/or customizing the simulator, the simulated images can represent an ideal fidelity image or a distorted medical image that corresponds to a specific type of hardware imperfection and/or a specific combination of multiple hardware imperfections. As such, the difficulty of collecting problem-specific medical images from imaging systems can be avoided.

According to another embodiment of the present invention, the method further comprises generating the virtual object based on a 2 dimensional natural image. Advantageously, the high flexibility in virtual object design allows a high quality 2D natural image to be used as the virtual object, instead of a 3D virtual object analogous to a given shape, tissue properties or other property of a patient.

According to yet another embodiment of the present invention, the method further comprises predetermining the hardware imperfection during a system imperfection characterization procedure of the imaging system.

According to yet another embodiment of the present invention, the imaging system comprises a magnetic resonance imaging system and wherein the hardware imperfection comprises B0 inhomogeneity, gradient delay, B1 inhomogeneity, coil sensitivity, eddy current, chain variability or combinations thereof.

According to yet another embodiment of the present invention, the method further comprises configuring the first simulation to simulate the magnetic resonance imaging system without the hardware imperfection and using a specific pulse sequence to obtain the first image, configuring the second simulation to simulate the magnetic resonance imaging system with the hardware imperfection and using the specific pulse sequence to obtain the second image, and generating the quality degradation model learnt with the mapping function specific for the magnetic resonance imaging system with the hardware imperfection and using the specific pulse sequence. As such, different mapping functions can be produced to correspond to different pulse sequences which are sensitive to different types of hardware imperfections. By corresponding each mapping function to a specific pulse sequence, the degradation behaviors of the imaging system under different pulse sequences can be recognized and used for further improving medical image correction.

Embodiments of the present invention provide an apparatus for medical image correction. The apparatus comprises a storage medium configured to store a plurality of input and output image pairs and a quality degradation model configured to learn a mapping function from an input degraded medical image measured from the medical imaging system to an output corrected medical image based on the plurality of input and out image pairs. The input image in each input and output image pair is generated from a first simulation of a medical imaging system without a hardware imperfection and the output image in each input and output image pair is generated from a second simulation of the medical imaging system with the hardware imperfection, thereby a quality degradation from the output image to the input image in each input and output image pair characterizing a type of quality degradation specific to the hardware imperfection.

According to one embodiment of the present invention, the apparatus further comprises a simulator of the medical imaging system configured to execute the first and second simulations.

According to another embodiment of the present invention, the storage medium is further configured to store a plurality of virtual objects for the first and second simulations.
According to yet another embodiment of the present invention, the hardware imperfection is predetermined during a system imperfection characterization procedure of the medical imaging system.

According to yet another embodiment of the present invention, the medical imaging system comprises a magnetic resonance imaging system and wherein the hardware imperfection comprises B0 inhomogeneity, gradient delay, B1 inhomogeneity, coil sensitivity, eddy current, chain variability or combinations thereof.

Embodiments of the present invention provide a method for correcting a quality degradation specific to a hardware imperfection of an imaging system in a medical image. The method comprises the steps of receiving the medical image by a quality degradation model learnt with a mapping function from a degraded input measured from the imaging system to a corrected output based on a plurality of input and out image pairs, and mapping a corrected medical image by the mapping function of the quality degradation model based on the received medical image. The output image in each input and output image pair comprises a first image generated from a first simulation of the imaging system without the hardware imperfection and the input image in each input and output image pair comprises a second image generated from a second simulation of the imaging system with the hardware imperfection, thereby a quality degradation from the output image to the input image in each input and output image pair characterizing a type of quality degradation specific to the hardware imperfection.

According to one embodiment of the present invention, the medical imaging system comprises a magnetic resonance imaging system and wherein the hardware imperfection comprises B0 inhomogeneity, gradient delay, B1 inhomogeneity, coil sensitivity, eddy current, chain variability or combinations thereof.

According to another embodiment of the present invention, the method further comprises predetermining the hardware imperfection during a system imperfection characterization procedure of the imaging system.

Embodiments of the present invention provide a computer program product comprising a computer-readable storage medium. The computer-readable storage medium has computer-readable program code embodied therewith, the computer-readable program code is configured to generate a quality degradation model of an imaging system with a hardware imperfection and/or correct a quality degradation specific to a hardware imperfection of an imaging system in a medical image when executed on at least one processor.

### DESCRIPTION OF THE DRAWINGS

The present invention will be described and explained hereinafter in more detail in combination with embodiments and with reference to the drawings, wherein:
The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.
Fig. 1 illustrates a schematic diagram of a system for generating a quality degradation model of an imaging system with a system hardware imperfection according to one embodiment of the present invention.
Fig.2 illustrates an exemplary application of a quality degradation model according to one embodiment of the present invention.
Fig.3 illustrates an exemplary interface of a simulator according to one embodiment of the present invention.

### DETAILED DESCRIPTION

Like numbered elements in these figures are either equivalent elements or perform the same function. Elements which have been discussed previously will not necessarily be discussed in later figures if the function is equivalent.

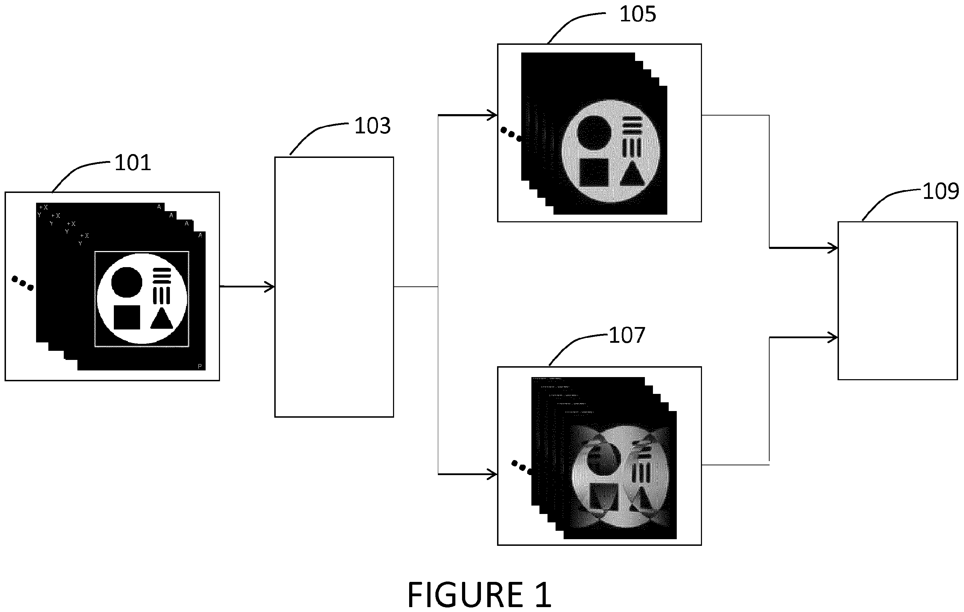

Fig. 1 illustrates a schematic diagram of a system 100 for generating a quality degradation model of an imaging system with a system hardware imperfection. The system 100 comprises a storage media including a first storage unit 101, a second storage unit 105 and a third storage unit 107, a virtual simulator 103 of the imaging system and a quality degradation model 109. The first storage unit 101 stores a plurality of virtual objects predesigned for image simulation of the virtual simulator 103, i.e. virtual phantoms for MR application. A virtual object of a given shape, tissue properties, signal intensity, etc., can be designed and input to the virtual simulator 103 as a virtual patient. Loaded with the virtual object and configured with the simulation setting, the virtual simulator 103 simulates imaging signal formation and image generation of the imaging system to output an image. Advantageously, when a first simulation with simulation settings characterizing an ideal imaging system without any system hardware imperfection, a first output image will be a high fidelity image without any distortion. When a second simulation with simulation settings characterizing the system hardware imperfection, a second output image will be degraded or corrupted by such system hardware imperfection to represent a quality distortion or artifacts characterizing the type of quality degradation specific to the system hardware imperfection. As such, a quality degradation from the first output image to the second output image represents a specific type of quality degradation associated with the hardware imperfection. The first output image and the second output image form an image pair that supervises the training of the quality degradation model 109. The first output image with the high fidelity is used as the output label and the degraded second output image is used as input image of the quality degradation model 109. To estimate the mapping function from the input image to output label with desirable accuracy, a sufficiently large set of such image pairs shall be generated and provided to the quality degradation model 109. Consequently, a large group of virtual objects shall be designed. Advantageously, virtual object design can have a high flexibility, instead of be analogous to a given shape, tissue properties or other property of a patient as required by common simulation experiments. Actually, instead of designing a 3D virtual object, a natural high quality 2D image can serve as a virtual object. In this instance, the quality degradation between the image pair simulated from the first simulation without the system hardware imperfection and the second simulation with the system hardware imperfection still represents the specific type of quality degradation associated with the system hardware imperfection, and therefore such image pair can still be used for the purpose of machine learning. The high quality image in each image pair is stored in the second storage unit 105 and the corresponding degraded image in each image pair is stored in the third storage unit 107.

With sufficient training image pairs received from the second storage unit 105 and the third storage unit 107, the quality degradation model 109 is trained to learn the mapping function that maps an input to an output based on the training input-output pairs, i.e. the degraded input image and the high fidelity output label. The learning analyzes the training data and produces the mapping function. When new input data is provided to the mapping function, an output for that input data is predicted. The learning stops when prediction of the mapping function achieves an acceptable level of accuracy.

The storage units 101, 105 and 107 maybe a graphics processing memory, a video random access memory, system memory, hard drive, optical media, magnetic media, flash drive, database, combinations thereof, or other now known or later developed memory device for storing image data. The storage units 101, 105 and 107 is part of the imaging system, part of a computer, part of a database, part of another system, a picture archival memory or a standalone device. The virtual simulator 103 and the quality degradation model 109 may be provided with a processor embedded with instructions for implementing the processes, methods and/or techniques discussed herein. The instructions are stored on a non-transitory computer readable storage media, which include various types of volatile and nonvolatile storage media. The functions, acts or tasks illustrated in the figures or described herein are executed in response to one or more sets of instructions stored in or on computer readable storage media. The processor is a general processor, central processing unit, control processor, graphics processor, digital signal processor, application specific integrated circuit, field programmable gate array, combinations thereof, or other now known or later developed machine. The processor may be a single device or multiple devices operating in serial, parallel or separately. The processor may be a main processor of a computer, or may be a processor for handling some tasks in a larger system, such as in the imaging system. The processor is configured by instructions, design, hardware, and/or software to perform the acts discussed herein.

Advantageously, by producing the training input-out image pairs from the virtual simulator 103, machine learning can be applied to medical image analysis applications where it is not practical to obtain satisfactory and sufficient training image data from image system measurements. Owing to the flexibility of virtual object design, sufficient training image data can be obtained from virtual simulations for the purpose of characterizing the specific type of quality degradation of the system hardware imperfection. The quality degradation model 109 learnt with the mapping function can be applied in a flexible fashion, e.g., implemented in an image reconstruction process, an image denoising process, or used as a standalone module specific for removing the type of distortion associated with the system hardware imperfection.

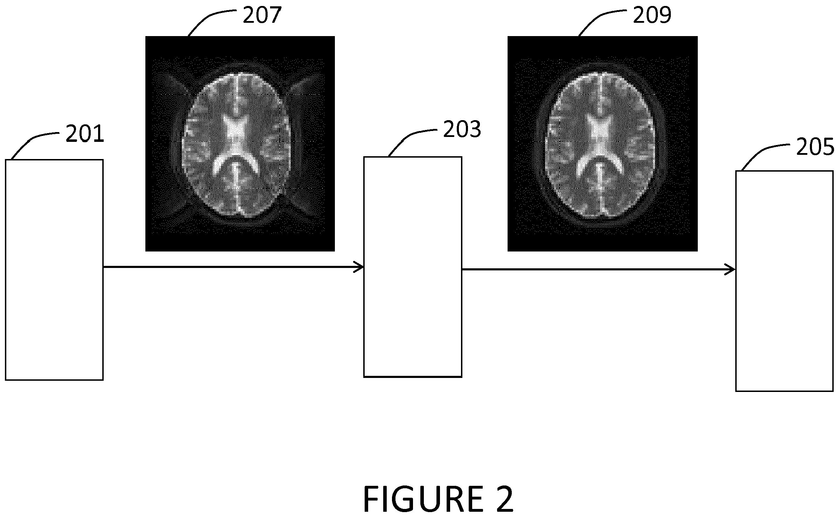

Fig.2 illustrates an exemplary application of a quality degradation model according to one embodiment of the present invention. A quality degradation model 203 has been pretrained by training input-out image pairs obtained from virtual simulations of an imaging system 201. A medial image 207 measured from the imaging system 201 is input to the quality degradation model 203, which predicts the output image 209 for the input. The output image 209 is further provided to a display 205 for displaying. As illustrated in FIGURE 2, the output image 209 has been restored from the input image 207 which has been distorted by the artifacts associated with the system hardware imperfection. The quality degradation model 203 can be integrated into the image reconstruction module of the imaging system 201 to output a high fidelity medical image not suffering from distortion caused by hardware imperfection or used as a single standalone device to further process the medical image from the imaging system 201 for correcting the artifacts specific to the hardware imperfection. Alternatively, the quality degradation model 203 can be integrated into other types of artifacts correction model, e.g., motion, shading, missing information in inpainting, and/or under-sampling to provide a comprehensive image correction model by taking the artifact with regards to the particular type of distortion caused by hardware imperfection into account.

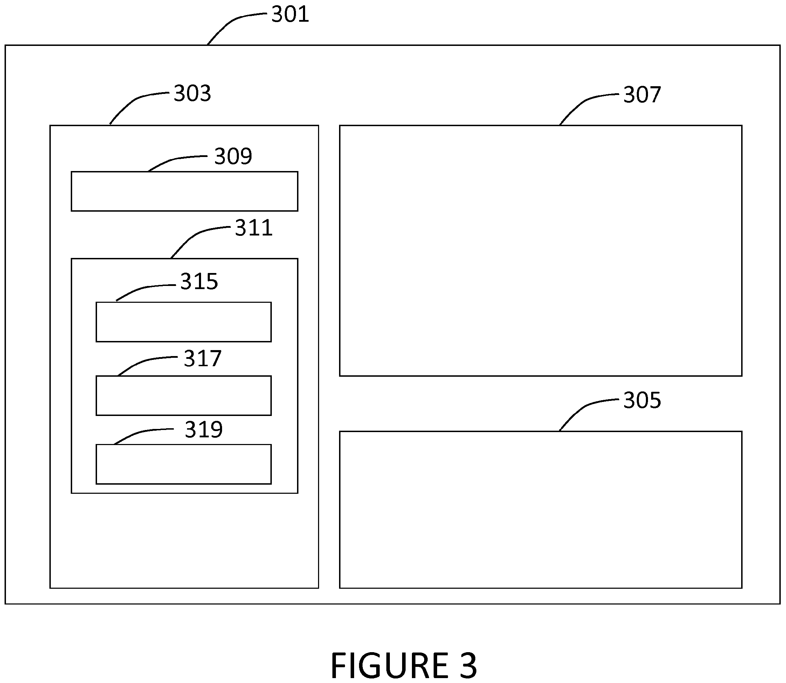

Fig.3 illustrates an exemplary interface of the virtual simulator according to one embodiment of the present invention. For the purpose of illustration, an interface 301 for a virtual magnetic resonance imaging (MRI) system is described in the embodiment of Fig.3. The interface 201 comprises a simulation setting zone 303, a virtual object design zone 305, and simulated image preview zone 307. The simulation setting zone 303 further comprises a sequence design zone 309 and a system hardware design zone 311. In one embodiment, the system hardware design zone 311 further comprises a magnet design zone 315, a coil design zone 317 and a gradient design zone 319. A structure of a virtual object consists of arbitrary number of object elements that are combined to create a virtual object. A desired virtual object can be constructed by changing the content within the object structure. Attributes of the object element can further be edited to generate different virtual object. A sufficiently large group of virtual objects can be created by modifying the object elements and attributes of each object element. These designed virtual objects are stored in a virtual object database. When performing a virtual simulation, control settings of the virtual object design zone 305 allows a user to load a virtual object from the virtual object database. With the loaded virtual object, control settings of the simulation setting zone 303 are enabled to configure a simulation experiment. More specifically, sequence settings of the sequence design zone 309 choose and load a predetermined pulse sequence, e.g., SPGR, SSFP, FSE etc., and configuration settings of the system hardware design zone 311 choose and load a predetermined system hardware configuration. The system hardware configuration further comprises the magnet configuration set at the magnet design zone 315, the coil configuration set at the coil design zone 317 and the gradient configuration set at the gradient design zone 319.

To perform a first MR simulation without system hardware imperfection, the magnet configuration is specified to characterize an uniform B0 field which is equivalent to the ideal condition without field inhomogeneity across the entire virtual object, the coil configuration is specified to characterize an uniform unit coil sensitivity for both RF transmitting and receiving, the gradient configuration is specified to characterize a constant unit gradient profile in the X, Y and Z direction which will maintain a linear spatial encoding in all three spatial dimensions without gradient delay. Alternatively, these ideal conditions can also be defined as default settings for MR simulations. By default, upon loading of the selected virtual object and pulse sequence, the MR virtual simulator parses the selected MR sequence and translates the sequence waveform into specific signal which triggers Bloch-equation kernel execution. The Bloch-equation solving kernels manipulate tissue spin evolution at discrete time interval with a desired spin model and at a given MR sequence. The acquired MR signal K-space data from the kernels passes to image reconstruction module whether a first simulated MR image without any distortion from system hardware imperfection is reconstructed for the selected virtual object.

To perform a second MR simulation with system hardware imperfection, the system hardware configuration characterizing the system hardware imperfection needs to be selected and loaded before executing the Bloch simulation with the system hardware imperfection. The system hardware imperfection comprises B0 field inhomogeneity, gradient non-linearity, eddy current, transmit field inhomogeneity, receive field imperfection, gradient coil vibration, B0 field drift or the combination thereof. There are a lot of methods for characterizing the system hardware imperfection, which is not described herein for the purpose of brevity. As the installation of the imaging system may affect the hardware features, the system hardware imperfection characterization procedure typically occurs during system installation and the predetermined system hardware imperfection is stored in a data file and ready for use. System hardware imperfection is always characterized by a set of numbers. For example, Spherical Harmonics can be used to characterize B0 field inhomogeneity. More specifically, after system hardware imperfection characterization procedure, harmonic coefficients for B0 field inhomogeneity are obtained and the field inhomogeneity can be calculated from these harmonic coefficients. This field inhomogeneity is added to the original field B in the Bloch-equation to perform the Bloch simulation with the system hardware imperfection. All the system hardware imperfections determined during the imaging system installation can be selected and loaded at the same time for the second MR simulation. As such, the distortion or artifacts of the second simulated MR image represents the type of quality degradation specific to the system hardware imperfection of the corresponding imaging system.

In one embodiment, to further enhance the performance of the quality degradation model learnt from these simulated high fidelity and distorted image pairs, multiple mapping functions can be produced from the machine learning and each mapping function corresponds to a combination of the system hardware imperfection and the pulse sequence. As different pulse sequences may be sensitive to different types of system hardware imperfections, the artefacts resulting in the MR images measured from the imaging system using different pulse sequences also have subtle difference. Therefore, when the system hardware imperfection of a MR scanner is determined, it is advantageous to simulate a set of MR image groups and each MR image group corresponds to a specific type of selected pulse sequence and the predetermined system hardware imperfection. As such, by using the MR image group simulated from the virtual MR simulator configured to the specific combination of the pulse sequence and the system hardware imperfection, a more accurate mapping function specific for a MR image measured from the MR scanner using the selected pulse sequence can be produced. As such, the performance of the quality degradation model is further improved.

The embodiment of Fig.3 is described in connection with magnetic resonance imaging. It should be understood by the skilled in the art virtual simulations of other imaging systems like ultrasound, computed tomography (CT), fluoroscopy, positron emission tomography (PET), x-ray, etc., can be contemplated to execute ideal simulations without system hardware imperfections and simulations characterizing system hardware imperfections. Simulated image pairs obtained from these simulations can be analyzed for learning the mapping function which predicts the quality enhanced output image from the measured input image.

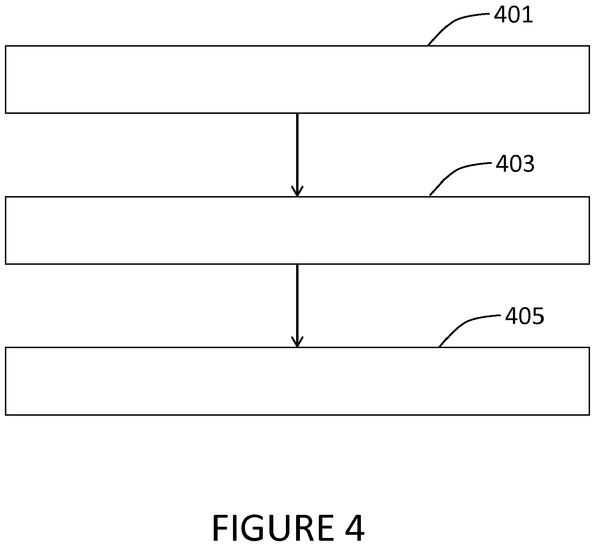

Fig.4 illustrates a flow chart of a method for generating a quality degradation model of an imaging system with hardware imperfection according to one embodiment of the present invention. The method is described in the context of MR medical imaging with reference to Figs.1 to 3, but may be applied in other medical devices. For example, in step 401, a first image from a first virtual simulation of an imaging system without the hardware imperfection is obtained. In the embodiment of Fig. 3, the first MR simulation without the hardware imperfection is performed by configuring the uniform B0 field, the uniform unit coil sensitivity for both RF transmitting and receiving, a constant unit gradient profile in X, Y and Z direction, so as to obtain a first simulated MR image without any distortion from system hardware imperfection. In step 403, a second image from a second virtual simulation of the imaging system with the hardware imperfection is obtained. In the embodiment of Fig. 3, a second MR simulation with the hardware imperfection is performed by configuring the B0 field inhomogeneity, gradient non-linearity, eddy current, transmit field inhomogeneity, receive field imperfection, gradient coil vibration, B0 field drift or the combination thereof predetermined during system hardware imperfection characterization procedure, so as to obtain the second simulated MR image with artifacts or distortions representing the type of quality degradation specific to the system hardware imperfection. In step 405, the quality degradation model learnt with a mapping function from an input degraded image measured from the imaging system to an output corrected image based on a plurality of input and out image pairs is generated. As illustrated in Fig. 1, the sufficient first and second simulated image pairs as generated in Fig. 3 is used as the training input-out image pairs for supervising the training of the quality degradation model 109. Since the quality degradation of the training input-out image pairs manifests the specific type of distortion or artifacts associated with the hardware imperfection, the mapping function estimated from analyzing these training image pairs can correct the specific type of distortion or artifacts associated with the hardware imperfection for an input medical image measured from the imaging system with the hardware imperfection. In the embodiment of Fig. 4, the steps are performed in the order shown (top to bottom or numerical), but other orders may be used. For example, step 403 can be performed prior to step 401. Alternatively, different acts may be provided to perform the steps. For example, the first and second image in steps 401 and 403 maybe obtained through loading image data generated through virtual simulation and stored in a computer, an imaging system, data storage media, a workstation and/or a server.
The embodiments described above are illustrative examples and it should not be construed that the present invention is limited to these particular embodiments. Thus, various changes and modifications may be effected by one skilled in the art without departing from the spirit or scope of the invention as defined in the appended claims.

## Claims

1. A method for correcting a type of quality degradation specific to a hardware imperfection of an imaging system in a medical image , the method comprising:
- obtaining a first image from a first simulation of the imaging system without the hardware imperfection;
- obtaining a second image from a second simulation of the imaging system with the hardware imperfection;
- generating a quality degradation model learnt with a mapping function from an input degraded image measured from the imaging system to an output corrected image based on a plurality of input and out image pairs, wherein the input image in each input and output image pair comprises the second image and the output image in each input and output image pair comprises the first image, and wherein a quality degradation from the output image to the input image in each image pair characterizes the type of quality degradation specific to the hardware imperfection;
- applying the quality degradation model to the medical image to correct the type of quality degradation specific to the hardware imperfection of the imaging system.

2. The method of claim 1, further comprising:
- obtaining an 1 object by a simulator of the imaging system;
generating the first image of the object by the simulator configured without the hardware imperfection; and
- generating the second image of the object by the simulator configured with the hardware imperfection.

3. The method of claim 2, further comprising:
generating the object based on a natural image.

4. The method of claim 1, further comprising:
predetermining the hardware imperfection during an installation of the imaging system.

5. The method of claim 1, wherein the imaging system comprises a magnetic resonance imaging system and wherein the hardware imperfection comprises B0 inhomogeneity, gradient delay, B 1 inhomogeneity, coil sensitivity, eddy current, chain variability or combinations thereof.

6. The method of claim 5, further comprising:
- configuring the first simulation to simulate the magnetic resonance imaging system without the hardware imperfection and using a specific pulse sequence to obtain the first image;
- configuring the second simulation to simulate the magnetic resonance imaging system with the hardware imperfection and using the specific pulse sequence to obtain the second image; and
- generating the quality degradation model learnt with the mapping function specific for the magnetic resonance imaging system with the hardware imperfection and using the specific pulse sequence.

7. An apparatus for medical image correction comprising:
- a storage medium configured to store a plurality of input and output image pairs, wherein the input image in each input and output image pair is generated from a first simulation of a medical imaging system without a hardware imperfection and the output image in each input and output image pair is generated from a second simulation of the medical imaging system with the hardware imperfection, thereby a quality degradation from the output image to the input image in each input and output image pair characterizing a type of quality degradation specific to the hardware imperfection; and
- a quality degradation model configured to learn a mapping function from an input degraded medical image measured from the medical imaging system to an output corrected medical image based on the plurality of input and out image pairs.

8. The apparatus of claim 7, further comprises:
a simulator of the medical imaging system configured to execute the first and second simulations.

9. The apparatus of claim 7, wherein the storage medium is further configured to store a plurality of objects for the first and second simulations.

10. The apparatus of claim 7, wherein the hardware imperfection is predetermined during a system imperfection characterization procedure of the medical imaging system.

11. The apparatus of claim 7, wherein the medical imaging system comprises a magnetic resonance imaging system and wherein the hardware imperfection comprises B0 inhomogeneity, gradient delay, B1 inhomogeneity, coil sensitivity, eddy current, chain variability or combinations thereof.

12. A method for correcting a quality degradation specific to a hardware imperfection of an imaging system in a medical image, the method comprising:
- receiving the medical image by a quality degradation model learnt with a mapping function from a degraded input measured from the imaging system to a corrected output based on a plurality of input and out image pairs, wherein the output image in each input and output image pair comprises a first image generated from a first simulation of the imaging system without the hardware imperfection and the input image in each input and output image pair comprises a second image generated from a second simulation of the imaging system with the hardware imperfection, thereby a quality degradation from the output image to the input image in each input and output image pair characterizing a type of quality degradation specific to the hardware imperfection; and
- mapping a corrected medical image by the mapping function of the quality degradation model based on the received medical image.

13. The method of claim 12, wherein the medical imaging system comprises a magnetic resonance imaging system and wherein the hardware imperfection comprises B0 inhomogeneity, gradient delay, B1 inhomogeneity, coil sensitivity, eddy current, chain variability or combinations thereof.

14. The method of claim 12, further comprising:
predetermining the hardware imperfection during a system imperfection characterization procedure of the imaging system.

15. A computer program product comprises a computer-readable storage medium having computer-readable program code embodied therewith, the computer-readable program code configured to perform all of the steps of any of claims 1-6 and claims 12-14 when executed on at least one processor.
